Europäisches Patentamt

European Patent Office

Office européen des brevets

(19)

(11) **EP 1 416 637 A1**

(12) **DEMANDE DE BREVET EUROPEEN**

(43) Date de publication:
**06.05.2004 Bulletin 2004/19**

(51) Int Cl.7: **H03K 23/00**, H03K 21/40,
G01C 22/02, G06F 7/60
// H03M7/16

(21) Numéro de dépôt: **03300160.3**

(22) Date de dépôt: **16.10.2003**

(84) Etats contractants désignés:
**AT BE BG CH CY CZ DE DK EE ES FI FR GB GR
HU IE IT LI LU MC NL PT RO SE SI SK TR**
Etats d'extension désignés:
**AL LT LV MK**

(30) Priorité: **28.10.2002 FR 0213457**

(71) Demandeur: **STMicroelectronics S.A.
92120 Montrouge (FR)**

(72) Inventeurs:
• **Wuidart, Luc
83910 Pourrieres (FR)**
• **Anguille, Claude
13090 Aix en Provence (FR)**

(74) Mandataire: **de Beaumont, Michel
1bis, rue Champollion
38000 Grenoble (FR)**

(54) **Compteur monotone croissant en circuit intégré**

(57)  L'invention concerne un compteur monotone croissant sur n bits réalisés en circuit intégré, comportant : un ensemble de $2^{n+1}-(n+2)$ cellules de comptage irréversible (11) réparties en au moins n groupes de $2^p-1$ cellules de comptage, où p désigne le rang du groupe ; et au moins n-1 calculateurs (40) de parité, chaque calculateur fournissant un bit de rang p, croissant à partir du bit de poids le plus fort du compte résultat, prenant en compte les états des cellules du groupe de même rang.

Fig 7

EP 1 416 637 A1

**Description**

La présente invention concerne le domaine des compteurs réalisés en circuit intégré. L'invention concerne plus particulièrement la réalisation d'un compteur monotone croissant irréversible.

Aujourd'hui, pour réaliser des compteurs monotones croissants, on est contraint d'utiliser des éléments fusibles qui présentent l'inconvénient notable de conduire à une programmation destructrice souvent incompatible avec une programmation au cours de fonctionnement du circuit intégré contenant l'élément fusible. Un autre exemple concerne les mémoires EPROM ou EEPROM dont la fabrication requiert des étapes non directement compatibles avec une technologie CMOS.

De plus, dans les deux cas, l'état de programmation réalisé est soit effaçable (cas des EEPROM) soit visible optiquement, ce qui est préjudiciable dans des applications de type sécuritaire pour lesquelles on souhaite disposer d'un compte inviolable.

Un exemple d'application consiste à compter le nombre d'événements par rapport à un seuil limite d'événements (nombre d'utilisation d'un programme ou durée d'utilisation). Dans ce type d'application, on souhaite généralement disposer d'un compteur dont chaque bit prend successivement les états 0 ou 1 de façon irréversible pour fournir un mot binaire représentatif du nombre d'événements apparus.

L'invention vise à proposer un compteur monotone croissant à programmation irréversible qui pallie les inconvénients des solutions connues.

L'invention vise notamment à proposer un tel compteur irréversible qui, dans l'état programmé, soit indétectable optiquement et qui soit compatible avec une technologie CMOS de fabrication du circuit intégré.

L'invention vise également à proposer un compteur monotone croissant dont la programmation et le fonctionnement soient compatibles avec des applications requérant un compte linéaire.

Pour atteindre ces objets et d'autres, la présente invention prévoit un compteur monotone croissant sur n bits réalisé en circuit intégré, comportant :

un ensemble de $2^{n+1} - (n+2)$ cellules de comptage irréversible réparties en au moins n groupes de $2p-1$ cellules de comptage, où p désigne le rang du groupe ; et
au moins n-1 calculateurs de parité, chaque calculateur fournissant un bit de rang p, croissant à partir du bit de poids le plus fort du compte résultat, prenant en compte les états des cellules du groupe de même rang.

Selon un mode de réalisation de la présente invention, le bit de poids le plus fort est fourni directement par l'unique cellule de comptage du groupe de rang 1.

Selon un mode de réalisation de la présente invention, le compteur comporte n calculateurs, le bit de poids le plus fort étant fourni par le calculateur prenant en compte l'état de l'unique cellule de comptage du groupe de rang 1.

Selon un mode de réalisation de la présente invention, chaque cellule de comptage est constituée d'une cellule mémoire à programmation unique dont un élément de mémorisation est constitué d'au moins une résistance en silicium polycristallin programmable par diminution irréversible de sa valeur.

L'invention prévoit également un procédé de commande d'un compteur, consistant à provoquer une programmation d'une cellule de comptage d'un groupe de rang inférieur à chaque fois que le contrôleur de parité d'un groupe de rang immédiatement supérieur détecte une parité.

Selon un mode de mise en oeuvre de la présente invention, on a recours à une machine d'états en logique câblée.

Selon un mode de mise en oeuvre de la présente invention, on a recours à un microcontrôleur.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1 illustre, par une vue partielle en perspective, un mode de réalisation d'une résistance en silicium polycristallin constituant l'élément de mémorisation d'une cellule de comptage selon l'invention ;
la figure 2 illustre, par un réseau de courbes, la programmation d'une cellule telle qu'illustrée par la figure 1 ;
la figure 3 représente un premier mode de réalisation d'une cellule de comptage selon la présente invention ;
la figure 4 représente un deuxième mode de réalisation d'une cellule de comptage selon la présente invention ;
la figure 5 représente un troisième mode de réalisation d'une cellule de comptage selon la présente invention ;
la figure 6 représente, de façon très schématique et sous forme de blocs, un compteur réalisé à partir de cellules de comptage à résistance en silicium polycristallin ;
la figure 7 représente un mode de réalisation d'un compteur monotone croissant selon la présente invention ;
la figure 8 illustre, par un tableau, les états respectifs pris par les sorties du compteur sur trois bits de la figure 7 ; et
la figure 9 représente un mode de réalisation d'un compteur de parité, appliqué à un compteur quatre bits selon l'invention.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, les différents signaux de commande du compteur et de ses éléments de décodage n'ont pas été détaillés et sont à la portée de l'homme du métier à partir de la description qui suit. De plus, la réalisation pratique d'une résistance en silicium polycristallin utilisable dans une cellule de comptage selon l'invention met en oeuvre des techniques classiques connues de l'homme du métier.

Une caractéristique de la présente invention est de prévoir des cellules de comptage dont l'élément de mémorisation est constitué d'une résistance en silicium polycristallin programmable par diminution irréversible de sa valeur.

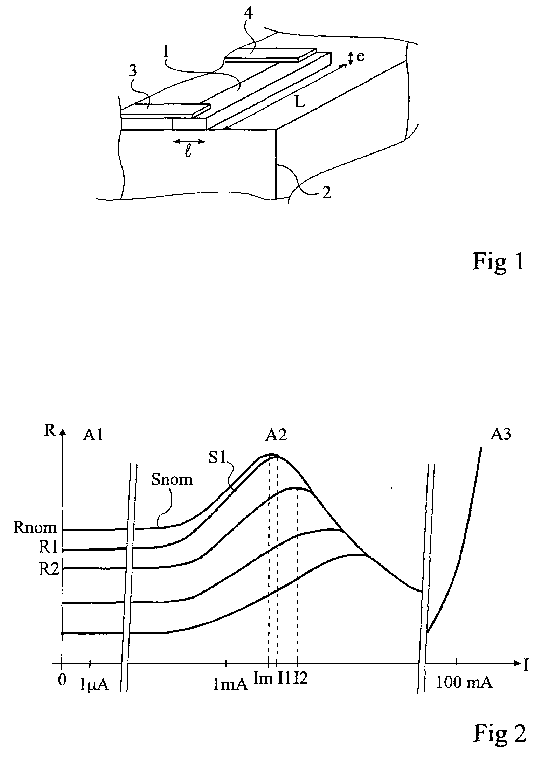

Cette caractéristique de l'invention ressortira mieux à l'issue de l'exposé des figures 1 et 2 qui va suivre et qui illustre les possibilités de programmation d'une résistance en silicium polycristallin exploitées par l'invention.

La figure 1 représente, par une vue partielle très schématique en perspective, un exemple de résistance en silicium polycristallin du type de celle utilisée dans une cellule de comptage selon l'invention.

Une telle résistance 1 est constituée d'une piste (dite aussi barreau) en silicium polycristallin obtenue par gravure d'une couche déposée sur un substrat 2 isolant. Le substrat 2 est indifféremment directement constitué du substrat du circuit intégré ou est constitué d'une couche isolante formant un substrat isolant ou équivalent pour la résistance 1. La résistance 1 est connectée, par ses deux extrémités, à des pistes conductrices (par exemple, métalliques) 3 et 4 destinées à raccorder le barreau résistif aux autres éléments du circuit intégré en fonction de l'application. La représentation schématique de la figure 1 ne fait pas référence aux différentes couches isolantes et conductrices constituant généralement le circuit intégré. Pour simplifier, on s'est contenté de représenter le barreau résistif 1 posé sur le substrat isolant 2 et en contact, par les extrémités de sa face supérieure, avec les deux pistes métalliques 3 et 4. En pratique, les liaisons de l'élément résistif 1 aux autres composants du circuit intégré sont obtenues par des pistes plus larges en silicium polycristallin partant des extrémités du barreau 1 dans l'alignement de celui-ci. En d'autres termes, l'élément résistif 1 est généralement formé en rendant un tronçon d'une piste en silicium polycristallin plus étroit que le reste de la piste.

La résistance R de l'élément 1 est donnée par la formule suivante :

$$R = \rho(L/s),$$

où $\rho$ désigne la résistivité du matériau (silicium polycristallin le cas échéant dopé) constituant la piste dans laquelle est gravé l'élément 1, où L désigne la longueur de l'élément 1, et où s désigne sa section, c'est-à-dire sa largeur 1 par son épaisseur e. La résistivité $\rho$ de l'élément 1 dépend, entre autre, du dopage éventuel du silicium polycristallin le constituant. Dans certains cas, on recouvre l'élément de silicium polycristallin par une couche de métal, l'élément résistif combinant alors le silicium polycristallin et le métal sur-jacent.

Le plus souvent, lors de la réalisation d'un circuit intégré, on prévoit les résistances en faisant référence à une notion dite de résistance par carreau $R_\square$ (square resistance). Cette résistance par carreau se définit comme étant la résistivité du matériau divisée par l'épaisseur avec laquelle il est déposé. En reprenant la relation ci-dessus donnant la résistance d'un élément 1, la résistance est donc donnée par la relation :

$$R = R_\square{}^* L/l.$$

Le quotient L/1 correspond à ce que l'on appelle le nombre de carreaux (square number) constituant l'élément résistif 1. Cela représente, vu de dessus, le nombre de carreaux de dimension donnée fonction de la technologie, mis côte à côte pour former l'élément 1.

La valeur de la résistance en silicium polycristallin est donc définie, à la fabrication, d'après les paramètres ci-dessus. Généralement, l'épaisseur e du silicium polycristallin est fixée par d'autres paramètres de fabrication du circuit intégré. Par exemple, cette épaisseur est fixée par l'épaisseur souhaitée pour les grilles des transistors MOS du circuit intégré.

Dans les technologies récentes, le recours à des résistances en silicium polycristallin est limité aux résistances devant être traversées, en fonctionnement, par des courants inférieurs à 100 µA. Pour des courants supérieurs, on utilise généralement une résistance de diffusion. Le silicium polycristallin est toutefois préféré à une diffusion de dopants, car on évite l'apparition de capacités parasites avec le substrat.

Pour diminuer irréversiblement la valeur d'une résistance en silicium polycristallin, on impose temporairement un courant dit de contrainte pour lequel la résistance passe par une valeur maximale, ce courant étant au-delà de la plage de courants de fonctionnement normal de cette résistance. En d'autres termes, on diminue la résistivité du silicium polycristallin dans la plage de courants de fonctionnement, de façon stable et irréversible, en imposant dans l'élément résistif correspondant la circulation d'un courant au-delà de la plage de courants de fonctionnement.

Le courant servant à diminuer la valeur de la résistance est, à la différence d'un élément fusible, non destructif pour l'élément en silicium polycristallin.

La figure 2 illustre, par un réseau de courbes donnant la résistance d'un élément en silicium polycristallin du type de celui représenté en figure 1 en fonction du courant le traversant, la façon de diminuer la résistance de cet élément.

On suppose que le silicium polycristallin ayant servi à la fabrication de l'élément résistif 1 présente une résistivité nominale conférant à l'élément 1, pour les dimensions 1, L et e données, une valeur de résistance $R_{nom}$. Cette valeur nominale (d'origine) de la résistance correspond à la valeur prise de façon stable par l'élément résistif 1 dans la plage de courants de fonctionnement du système, c'est-à-dire généralement pour des courants inférieurs à 100 μA.

Pour diminuer la valeur de la résistance et passer, par exemple, de façon irréversible et stable à une valeur R1 inférieure à $R_{nom}$, on applique aux bornes de l'élément résistif 1 un courant (par exemple I1), dit de contrainte, supérieur à un courant Im pour lequel la valeur de la résistance R de l'élément 1 est maximale sans toutefois être infinie. Comme l'illustre la figure 2, une fois que ce courant I1 a été appliqué à l'élément résistif 1, on obtient, dans la plage A1 de courants de fonctionnement du circuit intégré, une résistance stable de valeur R1. En fait, l'allure $S_{nom}$ de la résistance en fonction du courant est stable pour des courants relativement faibles (inférieurs à 100 μA). Cette allure se met à croître pour des courants sensiblement supérieurs de l'ordre de quelques milliampères, voire plus (plage A2). C'est dans cette plage de courants que l'allure Snom passe par un maximum pour la valeur Im. La résistance décroît ensuite progressivement. En figure 2, on a illustré une troisième plage A3 de courants correspondant à la plage généralement utilisée pour réaliser des fusibles. Il s'agit de courants de l'ordre du dixième d'ampère où la résistance se met à croître brusquement jusqu'à devenir infinie. Par conséquent, on peut considérer que l'invention utilise la plage intermédiaire A2 de courants entre la plage de fonctionnement A1 et la plage destructrice A3, pour diminuer de façon irréversible la valeur de la résistance ou plus précisément de la résistivité de l'élément en silicium polycristallin.

En effet, une fois passé le maximum de l'allure Snom de la résistivité en fonction du courant, la valeur prise par la résistance dans la plage de courants de fonctionnement se trouve inférieure à la valeur $R_{nom}$. La nouvelle valeur, par exemple R1, dépend de la valeur la plus élevée du courant (ici, I1) qui a été appliqué pendant la phase de diminution irréversible. On notera en effet que la diminution irréversible opérée par l'invention s'effectue dans une phase spécifique, hors du fonctionnement normal (plage A1) du circuit intégré, c'est-à-dire hors du fonctionnement normal de la résistance.

Une fois que la valeur de la résistance en silicium polycristallin a été abaissée vers une valeur inférieure (par exemple R1 en figure 2), on peut encore procéder à une diminution irréversible de cette valeur. Il suffit pour cela de dépasser le courant maximum I1 de la nouvelle allure S1 de la résistance en fonction du courant. Par exemple, on peut accroître la valeur du courant jusqu'à atteindre une valeur I2. Quand le courant est alors de nouveau diminué, on obtient une valeur R2 pour la résistance dans sa plage de fonctionnement normal. La valeur R2 est inférieure à la valeur R1 et, bien sûr, à la valeur $R_{nom}$.

On voit que toutes les allures de la résistance en fonction du courant se rejoignent sur la pente de décroissance de la valeur de la résistance, après être passées par le maximum de l'allure. Ainsi, pour un élément résistif donné ($\rho$, L, s), les courants I1, I2, etc. qui doivent être atteints, pour passer à une valeur de résistance inférieure, sont indépendants de la valeur de la résistance (Rnom, R1, R2) à partir de laquelle on provoque la diminution.

Ce qui a été exprimé ci-dessus comme valeur de résistance correspond en fait à une diminution de la résistivité du silicium polycristallin constituant l'élément résistif. Les inventeurs considèrent que l'on assiste à une modification stable de la structure cristalline du silicium polycristallin et que l'on assiste, en quelque sorte, à un fluage du matériau, la structure cristalline finale obtenue dépendant du courant maximum atteint. En fait, le courant de contrainte provoque une élévation de température de l'élément en silicium, ce qui entraîne un fluage de celui-ci.

Bien sûr, on veillera à ne pas dépasser la plage de courants de paramétrage A2 (de l'ordre de quelques milliampères) afin de ne pas risquer de détruire la résistance en silicium polycristallin. Cette précaution ne posera en pratique pas de problème dans la mesure où l'utilisation du silicium polycristallin pour constituer un fusible requiert des courants nettement plus élevés (de l'ordre du dixième d'ampère) qui ne sont pas disponibles une fois le circuit fabriqué.

La réalisation pratique d'une résistance en silicium polycristallin ne diffère pas de la réalisation d'une résistance classique. Partant d'un substrat isolant, on dépose une couche de silicium polycristallin que l'on grave en fonction des dimensions souhaitées pour la résistance. Comme l'épaisseur de silicium polycristallin déposée est généralement fixée par la technologie, les deux dimensions que l'on peut régler sont la largeur et la longueur. Généralement, on redépose un isolant sur le barreau de silicium polycristallin ainsi obtenu. Dans le cas d'une interconnexion en ligne, on aura modifié la largeur 1 par rapport aux pistes d'accès plus larges pour être fortement conductrices. Dans le cas d'un accès aux extrémités du barreau par le dessus comme cela est illustré en figure 1, on réalisera des vias dans l'isolant sur-jacent (non représenté) du barreau de silicium polycristallin pour connecter des pistes métalliques 3 et 4 de contact.

En pratique, pour disposer de la capacité de réglage de résistance la plus importante avec un courant de contrainte minimum, on cherchera à utiliser une épaisseur minimale et une largeur minimale pour les éléments résistifs. Dans ce cas, seule la longueur L conditionne la valeur nominale de la résistance une fois la structure du silicium polycristallin fixée. Le dopage éventuel du silicium polycristallin, quel que soit son type, n'entrave pas la mise en oeuvre de l'invention. La seule différence liée au dopage est la résistivité nominale avant contrainte et les résistivités obtenues pour des courants de contraintes donnés. En d'autres termes, pour un élément de dimensions données, cela conditionne le point de départ de la valeur de la résistance, et par voie de conséquence, les valeurs de résistance obtenues pour des courants de contrainte donnés.

Pour passer de la valeur nominale à une valeur de résistance ou résistivité inférieure, ou pour passer d'une valeur donnée (inférieure à la valeur nominale) à une valeur encore inférieure, on peut utiliser plusieurs méthodes.

Par exemple, on fait croître progressivement (pas à pas) le courant dans la résistance. Après chaque application d'un courant supérieur, on revient dans la plage de courants de fonctionnement et on mesure la valeur de la résistance. Tant que le point Im de courant n'est pas atteint, cette valeur de résistance restera à la valeur $R_{nom}$. Dès que le point Im en courant est dépassé, on change de courbe (allure S) et la valeur mesurée lorsque l'on repasse sur les courants de fonctionnement devient une valeur inférieure à la valeur $R_{nom}$. Si cette nouvelle valeur convient, on en reste là. Dans le cas contraire, on réapplique des courants supérieurs pour dépasser la nouvelle valeur maximale de l'allure courante. Dans ce cas, il n'est pas nécessaire de repartir des courants minimaux comme lorsque l'on démarre de la résistance nominale. En effet, la valeur du courant pour laquelle la résistance va de nouveau diminuer est forcément supérieure à la valeur du courant de contrainte I1 appliqué pour passer sur l'allure courante. La détermination du pas à appliquer est à la portée de l'homme du métier et n'est pas critique en ce qu'elle conditionne essentiellement le nombre de diminutions possibles. Plus le pas est élevé, plus les sauts entre les valeurs seront importants.

Selon un autre exemple préféré, on prédétermine, par exemple par mesures, les différents courants à appliquer pour passer des différentes valeurs de résistance à des valeurs inférieures. Cette prédétermination tient compte bien entendu de la nature du silicium polycristallin utilisé ainsi que préférentiellement de la résistance par carreau c'est-à-dire de la résistivité du matériau et de l'épaisseur dans laquelle il est déposé. En effet, comme les allures illustrées par la figure 2 peuvent également être lues comme allure de la résistance par carreau, on est en mesure de transposer les valeurs calculées aux différentes résistances d'un circuit intégré définies par les largeurs et longueurs des tronçons résistifs. Selon ce deuxième mode de mise en oeuvre, on est alors en mesure de prédéterminer la valeur du courant de contrainte à appliquer à l'élément résistif pour diminuer, de façon irréversible et stable, sa valeur.

Le changement de courbes, c'est-à-dire la diminution de la valeur de résistance en fonctionnement normal est quasi immédiate dès que le courant de contrainte correspondant est appliqué. Par quasi-immédiat, on entend une durée de quelques dizaines voir centaines de microsecondes qui suffisent pour appliquer la contrainte correspondante au barreau de silicium polycristallin et diminuer la valeur de sa résistance. Cette valeur empirique dépend de la taille (physique) du barreau. On pourra choisir une durée de quelques millisecondes par sécurité. De plus, on peut considérer que, une fois la durée minimale atteinte, toute durée supplémentaire d'application du courant de contrainte ne modifie pas, au moins au premier ordre, la résistance atteinte. En outre, même si dans une application particulière on considère ne pas pouvoir négliger l'influence de la durée d'application de la contrainte, les deux méthodes sont parfaitement compatibles avec la prise en compte de la durée d'application de la contrainte.

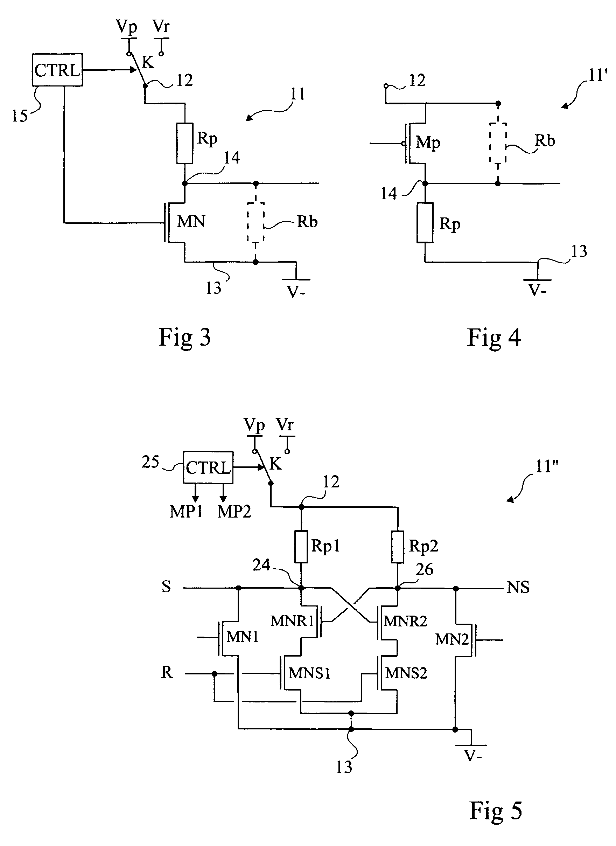

La figure 3 représente un premier mode de réalisation d'une cellule de comptage à programmation unique (ou cellule mémoire) selon l'invention.

La cellule 11 comporte, en série avec une première borne 12 d'application d'un potentiel positif d'alimentation et une deuxième borne 13 d'application d'un potentiel plus négatif d'alimentation V- ou de référence (généralement, la masse), une résistance programmable Rp par diminution irréversible telle que décrite ci-dessus en relation avec les figures 1 et 2 et un interrupteur de programmation ici un transistor MOS à canal N (MN). La résistance Rp constitue l'élément de mémorisation de la cellule 11. L'état stocké dans cette cellule est lu sur le point milieu 14 de l'association en série de la résistance Rp avec le transistor MN. La lecture du niveau mémorisé s'effectue par comparaison par rapport à un niveau de référence.

Pour permettre la lecture de l'état mémorisé dans la cellule 11, on prévoit une résistance Rb (représentée en pointillés en figure 3) qui, lorsque le transistor MN est ouvert constitue avec la résistance Rp un pont diviseur de tension. La résistance Rb a été représentée en pointillés pour illustrer son caractère optionnel. En effet, celle-ci pourra être constituée par le transistor MN alors polarisée dans une partie linéaire de sa caractéristique et non en saturation.

Le transistor MN, lorsqu'il est passant, court-circuite (au moins fonctionnellement) la résistance fixe Rb et sert à programmer la résistance Rp en imposant la circulation d'un courant dans celle-ci. Le courant de programmation de la résistance Rp est supérieur au courant pour lequel cette résistance présente une valeur maximale déterminée comme cela a été exposé précédemment en relation avec les figures 1 et 2.

La plage nominale des courants de fonctionnement d'une résistance en silicium polycristallin utilisée selon l'invention est inférieure à la centaine de microampères et, le plus souvent, inférieure à la dizaine de microampères. L'amplitude des courants de programmation est de l'ordre du milliampère.

La programmation d'une cellule telle qu'illustrée par la figure 3 est rendue possible en prévoyant une sélection du potentiel positif d'alimentation appliqué à la borne 12 entre un potentiel Vr de lecture (propre à engendrer un courant de l'ordre du microampères) et un potentiel Vp de programmation (propre à engendrer un courant de l'ordre du milliampères) . La sélection est opérée au moyen d'un interrupteur K commandé par un circuit 15 de commande (CTRL) fournissant par ailleurs le signal de commande adapté au transistor MN.

L'opération de comptage consiste à provoquer la diminution irréversible de la valeur de la résistance Rp en lui appliquant un courant de contrainte. En lecture, la comparaison du potentiel d'une cathode par rapport à une valeur de référence permet de déterminer si la cellule de comptage contient un état 0 ou un état 1.

La figure 4 représente un deuxième mode de réalisation d'une cellule de comptage 11' selon l'invention. Cette cellule diffère de la cellule de la figure 3 par le fait que le transistor de programmation MP utilisé est un transistor MOS à canal P. Le transistor MP est connecté entre la borne 12 et le point 14 de lecture. La résistance de programmation Rp est connectée entre le point 14 et la borne 13 d'application du potentiel de référence. En figure 4, l'interrupteur K et le circuit de commande 15 bien que toujours présents, n'ont pas été représentés. La résistance Rb en pointillés a été symbolisée en parallèle sur le transistor MP.

Le fonctionnement d'une cellule 11' telle que représentée en figure 4 est similaire à celui de la cellule 11 de la figure 3. Cette dernière constitue cependant un mode de réalisation préféré en raison du moindre encombrement du transistor MOS à canal N par rapport au transistor MOS à canal P.

La figure 5 représente un troisième mode de réalisation d'une cellule 11" de comptage irréversible selon la présente invention. La différence essentielle par rapport aux cellules de comptage représentées aux figures 3 et 4 est que la structure de la figure 5 est une structure différentielle ne recourant donc pas de potentiel de référence pour effectuer la comparaison permettant de détecter l'état stocké dans la cellule.

La cellule 11" de la figure 5 comporte deux branches résistives en parallèle entre deux bornes 12 et 13 d'alimentation, deux interrupteurs de programmation MN1 et MN2 (dans cet exemple, des transistors MOS à canal N), un circuit de commande 25 (CTRL) et un sélecteur K entre deux tensions d'alimentation, respectivement de lecture Vr et de programmation Vp. La programmation d'une cellule telle qu'illustrée par la figure 5 s'effectue de façon similaire à celle des cellules des figures 3 et 4. Ce qui change ici, c'est la structure de la cellule pouvant permettre la lecture.

Dans le mode de réalisation de la figure 5, une première branche, dite gauche dans l'orientation de la figure comporte en série, une première résistance Rp1, un transistor MOS de lecture MNR1, et un transistor MOS de sélection MNS1. L'interconnexion entre la résistance Rp1 et le transistor MNR1 constitue une première borne S de sortie dite arbitrairement directe (non inversée). La borne S correspond également au point 24 de liaison de la résistance Rp1 au transistor de programmation MN1. Une deuxième branche dite droite dans l'orientation de la figure, comporte en série, une deuxième résistance Rp2, un transistor MOS de lecture MNR2 et un transistor MOS de sélection MNS2. L'interconnexion entre la résistance Rp2 et le transistor MNR2 (donc le drain de ce transistor) constitue une deuxième borne NS de sortie inverse par rapport à la borne S. La sortie NS correspond également au point 26 de liaison de la résistance Rp2 au transistor de programmation MN2. La grille du transistor MNR2 est reliée à la borne 24 tandis que la grille du transistor MNR1 est reliée à la borne 26 pour obtenir l'effet d'un bistable. Les grilles des transistors MNS1 et MNS2 sont reliées ensemble à une borne R destinée à recevoir un signal de sélection en lecture de la cellule de comptage. Ce signal correspond, de préférence, au signal de sélection de la cellule de comptage dans un agencement unidirectionnel de plusieurs cellules. Il est alors fourni par le décodeur de colonnes ou de lignes adapté. Dans l'exemple représenté, tous les transistors sont à canal N.

Le fonctionnement en lecture d'une cellule selon ce mode de réalisation est le suivant. Le circuit 25 provoque la commutation du sélecteur K vers le potentiel Vr. De préférence, il s'agit de son état de repos dans la mesure où l'autre état ne sert qu'en programmation (donc, en principe, une seule fois par cellule). La borne d'entrée R reçoit le signal (actif à l'état haut) de sélection (ou de configuration de lecture) de la cellule, rendant conducteur les deux transistors MNS1 et MNS2.

Il en découle qu'une des bornes MNS voit son potentiel croître plus vite que l'autre. Ce déséquilibre provient de la différence de valeur entre les résistances Rp1 et Rp2. Il provoque la conduction d'un des transistors MNR1 et MNR2. En raison du croisement des grilles de ces transistors, celui qui conduit le premier est celui dont la grille participe au chemin électrique (depuis la borne 12) de constante de temps la plus faible (la résistance de valeur la plus faible engendre une constante de temps plus faible), donc celui dont le potentiel de drain croît moins vite que l'autre. Une fois conducteur, ce transistor MNR force son drain (donc la borne de sortie S ou NS correspondante) à la masse 13, ce qui confirme le blocage du transistor MNR de l'autre branche, donc l'état haut sur la borne de sortie correspondante.

La programmation d'une cellule selon ce mode de réalisation s'effectue de la même manière que pour les deux premiers modes de réalisation, à l'aide d'un des transistors MN1 et MN2. Toutefois, les transistors MNS1 et MNS2 de la cellule de comptage doivent être bloqués lors de la programmation (entrée R au niveau bas). Ils servent à protéger les transistors de lecture MNR1 et MNR2 en rendant leurs sources flottantes, évitant ainsi l'apparition de tensions grille-source destructrices en raison de la tension d'alimentation Vp. De plus, en déconnectant les transistors MNR par leurs sources, les transistors MNS empêchent qu'ils voient, entre drain et source, la tension élevée Vp. Par conséquent, les transistors MNR et MNS peuvent être dimensionnés en fonction de la tension de lecture Vr. Seuls les transistors de programmation MN ont besoin d'être dimensionnés pour tenir la tension Vp et supporter le courant relativement élevé (par rapport à la plage de fonctionnement en lecture) servant à programmer la cellule.

Comme pour le mode de réalisation de la figure 3, celui de la figure 5 s'applique également à des transistors MOS à canal P. La transposition du mode de réalisation de la figure 5 à des transistors MOS à canal P est à la portée de l'homme du métier.

Selon une variante de réalisation, on pourra utiliser une seule tension d'alimentation pour la cellule de comptage. On évite ainsi la sélection de la tension d'alimentation entre les niveaux Vp et Vr. Dans ce cas, on choisit une tension d'alimentation suffisante pour imposer la contrainte souhaitée à la programmation des résistances Rp1 et Rp2 (figure 5), ou de la résistance Rp (figures 3 et 4). Les dimensions des transistors sont alors choisies en conséquence.

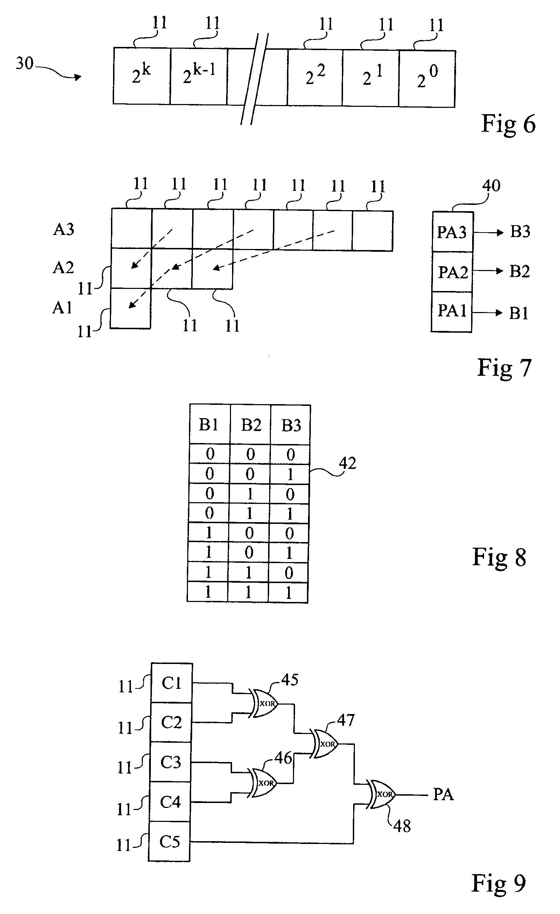

La figure 6 représente un mode de réalisation d'un compteur 30 de k+1 cellules 11 du type de celle illustrée en relation avec les figures 3 à 5. Chaque cellule de comptage possède un état 0 ou 1.

Dans une lecture directe du résultat d'un compteur de la figure 6, chaque bit peut prendre un état 0 ou un 1. Toutefois, une fois qu'une cellule de comptage a été programmée dans un état 1, le fait que sa programmation soit irréversible fait que le comptage ne peut pas être linéaire en exploitant directement les sorties du compteur 30.

La figure 7 représente un mode de réalisation préféré d'un compteur monotone croissant et linéaire selon la présente invention.

Une caractéristique de l'invention est d'associer, à des cellules de comptage irréversibles telles que décrites précédemment, un calculateur 40 de parité permettant d'obtenir virtuellement des états 0 même après programmation d'états 1.

L'exemple de la figure 7 concerne un compteur sur trois bits comprenant onze cellules à programmation unique du type de celles décrites en relation avec les figures 3 à 5. Ces cellules sont réparties en trois groupes ou lignes A3, A2 et A1 représentant les bits du compteur. Pour un compteur trois bits, la ligne A3 correspondant au bit de poids faible (ou le moins significatif) comporte sept cellules associées à un calculateur de parité PA3. La ligne A2 correspondant à un bit de poids intermédiaire comporte trois cellules associées à un calculateur de parité PA2. La ligne A1 correspondant au bit de poids fort (ou le plus significatif) ne comporte qu'une cellule (de préférence associée à un calculateur de parité PA1 pour des raisons de régularité de structure). Le résultat du compteur, c'est-à-dire les états B1, B2 et B3 sont fournis par les calculateurs de parité 40 représentant respectivement les bits plus significatif, intermédiaire et moins significatif.

Selon l'invention, à chaque fois que le compteur doit être incrémenté, les cellules de comptage sont adressées de façon particulière en fonction de la taille du compteur afin d'obtenir le calcul de parité souhaité fournissant un compte linéaire.

La figure 8 illustre, par un tableau 42, les états successifs pris par le compteur linéaire de la figure 7 et sera décrite en relation avec un exemple d'adressage des cellules de comptage de cette figure 7.

On suppose que toutes les cellules 11 de la figure 7 sont à l'état zéro au départ. Les calculateurs de parité contiennent donc également des valeurs zéro (première ligne du tableau 42).

Le comptage s'effectue en commençant par remplir la ligne A3 de la gauche vers la droite dans l'orientation de la figure 7. Le premier état est donc 001, seul le compteur de parité PA3 fournissant un état 1. Selon l'invention, à chaque passage sur unité paire décodée par un compteur de parité 40, on incrémente une des cellules de comptage de la ligne suivante. Ainsi, lorsqu'un état 1 est programmé dans une deuxième cellule de la ligne A3, le calculateur PA3 fournit une parité à zéro, ce qui déclenche la programmation à l'état 1 d'une des cellules de la ligne A2. Le calcul de parité effectué par le calculateur PA2 fournit alors un 1 alors que le calcul PA3 fournit un zéro (troisième ligne du tableau 42). Ce fonctionnement de comptage se poursuit jusqu'à ce que tous les compteurs de parité fournissent un état 1. Les décalages successifs d'une ligne à l'autre par l'adressage en comptage ont été illustrés par des flèches en pointillés en figure 7.

La programmation d'une cellule de comptage d'une ligne de rang supérieur en même temps que la cellule de rang inférieur peut être effectuée, soit à partir d'une machine d'états en logique câblée, soit à partir d'un microcontrôleur.

Selon l'invention, c'est la fonction d'adressage de programmation qui conditionne les états de sortie du compteur. Cette fonction de programmation peut, le cas échéant, évoluer en fonction du comptage en temps réel, par exemple, pour conserver une trace de l'évolution d'un phénomène où chaque cellule de comptage programmée correspondrait à l'apparition d'un événement. Par exemple, on peut ainsi suivre un historique de manipulations électriques, d'essais, etc. ou effectuer un enregistreur à sens unique.

On peut également prévoir une fonction de séquençage de la programmation des cellules du compteur de façon univoque en logique câblée. Par exemple, pour faire en sorte que, dans une étape de programmation donnée, on ait en sortie un et un seul mot servant par exemple de clé évolutive au déblocage d'une fonction particulière (par exemple, un algorithme de chiffrement dans une application à la télévision à péage).

Bien entendu, si les cellules de comptage ont été représentées dans trois lignes distinctes en figure 7 pour en clarifier l'exposé, celles-ci pourront être en pratique réalisées sous la forme d'un arrangement matriciel, les fonctions d'adressage correspondant aux fonctions de programmation de comptage souhaitées selon les résultats donnés par les calculateurs de parité.

De façon plus générale, pour obtenir un compteur sur n bits, le nombre de cellules de comptage nécessaires est $2^{n+1}-(n+2)$.

Les répartitions des cellules (nombre de cellules par ligne) en se reportant au mode de réalisation de la figure 7 sont pour p (compris entre 1 et n) représentant le rang du décodeur de parité, 2p-1.

On voit donc que toutes les lignes possèdent un nombre impair de cellules de comptage.

La figure 9 représente un exemple de calculateur de parité pour quatre cellules C1 à C5. Les sorties respectives des cellules C1 à C4 sont combinées deux à deux par des portes de type OU-Exclusif (XOR) 45 et 46 dont les sorties respectives sont une nouvelle fois combinée par une porte XOR 47. La sortie de la porte 47 est combinée avec la sortie de la cellule C5 par une porte XOR 48 fournissant la parité PA des cinq cellules concernées.

Un avantage de la présente invention est qu'elle permet de réaliser un compteur monotone croissant et linéaire, sans que le contenu de ce compteur soit observable.

Un autre avantage de la présente invention est que sa réalisation est compatible avec une technologie CMOS standard, c'est-à-dire que l'invention est applicable à tous les circuits sans nécessiter d'EEPROM embarquée.

Un autre avantage de l'invention est que l'invention est compatible avec une réalisation en logique câblée et qu'elle peut fonctionner sans horloge.

Un autre avantage de la présente invention, trouvant un intérêt tout particulier dans une application sécuritaire, est que pour le cas où un pirate éventuel effectue une programmation d'une quelconque des cellules, soit la cellule a déjà été programmée et cela n'effectue aucun changement au compteur, soit la cellule n'était pas dans un état programmé et le nombre d'essais de programmation résiduels se trouve limité.

Bien entendu, la présente invention est susceptible de diverses variantes et modifications qui apparaîtront à l'homme de l'art. En particulier, la réalisation de la fonction d'adressage en programmation, c'est-à-dire en comptage, est à la portée de l'homme du métier à partir des indications fonctionnelles données ci-dessus et de l'application.

**Revendications**

1. Compteur monotone croissant sur n bits réalisé en circuit intégré, **caractérisé en ce qu'**il comporte :

   un ensemble de $2^{n+1}-(n+2)$ cellules de comptage irréversible (11, 11' ; 11") réparties en au moins n groupes de 2p-1 cellules de comptage, où p désigne le rang du groupe ; et
   au moins n-1 calculateurs (40) de parité, chaque calculateur fournissant un bit de rang p, croissant à partir du bit de poids le plus fort du compte résultat, prenant en compte les états des cellules du groupe de même rang.

2. Compteur selon la revendication 1, **caractérisé en ce que** le bit de poids le plus fort est fourni directement par l'unique cellule de comptage du groupe de rang 1.

3. Compteur selon la revendication 1, **caractérisé en ce qu'**il comporte n calculateurs, le bit de poids le plus fort étant fourni par le calculateur prenant en compte l'état de l'unique cellule de comptage du groupe de rang 1.

4. Compteur monotone selon l'une quelconque des revendications 1 à 3, **caractérisé en ce que** chaque cellule de comptage est constituée d'une cellule mémoire à programmation unique (11, 11' ; 11") dont un élément de mémorisation est constitué d'au moins une résistance en silicium polycristallin (Rp ; RP1, Rp2) programmable par diminution irréversible de sa valeur.

5. Procédé de commande d'un compteur selon l'une quelconque des revendications 1 à 4, **caractérisé en ce qu'**il consiste à provoquer une programmation d'une cellule de comptage d'un groupe de rang inférieur à chaque fois que le contrôleur de parité d'un groupe de rang immédiatement supérieur détecte une parité.

6. Procédé selon la revendication 5, **caractérisé en ce qu'**il est mis en oeuvre par une machine d'états en logique câblée.

7. Procédé selon la revendication 5, **caractérisé en ce qu'**il est mis en oeuvre par un microcontrôleur.

Fig 1

Fig 2

Fig 3

Fig 4

Fig 5

10

Fig 6

Fig 7

| B1 | B2 | B3 |
|----|----|----|
| 0 | 0 | 0 |
| 0 | 0 | 1 |
| 0 | 1 | 0 |
| 0 | 1 | 1 |
| 1 | 0 | 0 |
| 1 | 0 | 1 |
| 1 | 1 | 0 |
| 1 | 1 | 1 |

Fig 8

Fig 9

**Office européen
des brevets**

## RAPPORT DE RECHERCHE EUROPEENNE

Numéro de la demande

EP 03 30 0160

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 6 433 725 B1 (SIVILOTTI MASSIMO ANTONIO ET AL) 13 août 2002 (2002-08-13) * figure * --- | 1-7 | H03K23/00 H03K21/40 G01C22/02 G06F7/60 //H03M7/16 |
| A | DE 101 01 575 A (INFINEON TECHNOLOGIES AG) 25 juillet 2002 (2002-07-25) * alinéa '0013!; revendication 5 * --- | 1 | |
| A | US 5 418 738 A (ELLIS WAYNE F ET AL) 23 mai 1995 (1995-05-23) * abrégé * ----- | 4 | |

| DOMAINES TECHNIQUES RECHERCHES (Int.Cl.7) |
|---|
| H03K H03M G07F G06M G01C G11C |

Le présent rapport a été établi pour toutes les revendications

| Lieu de la recherche | Date d'achèvement de la recherche | Examinateur |
|---|---|---|
| LA HAYE | 10 février 2004 | Verhoof, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.....................................................................
& : membre de la même famille, document correspondant

EPO FORM 1503 03 82 (P04C02)

**ANNEXE AU RAPPORT DE RECHERCHE EUROPEENNE
RELATIF A LA DEMANDE DE BREVET EUROPEEN NO.**

EP 03 30 0160

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-02-2004

| Document brevet cité au rapport de recherche | | Date de publication | Membre(s) de la famille de brevet(s) | | Date de publication |
|---|---|---|---|---|---|
| US 6433725 | B1 | 13-08-2002 | AUCUN | | |
| DE 10101575 | A | 25-07-2002 | DE | 10101575 A1 | 25-07-2002 |
| US 5418738 | A | 23-05-1995 | US | 5334880 A | 02-08-1994 |
| | | | EP | 0511560 A2 | 04-11-1992 |
| | | | JP | 2557160 B2 | 27-11-1996 |
| | | | JP | 5101687 A | 23-04-1993 |

EPO FORM P0460

Pour tout renseignement concernant cette annexe : voir Journal Officiel de l'Office européen des brevets, No.12/82